# EUROPEAN PATENT APPLICATION

(11) **EP 4 462 468 A1**
(43) Date of publication of application: **13.11.2024**
(21) Application number: 24173456.5
(22) Date of filing: 30.04.2024
(51) Int. Cl.: H01L 21/48, H01L 23/498, H01L 21/683

(54) **CORELESS SUBSTRATES AND MANUFACUTRING METHODS THEREOF**

(30) Priority: 09.05.2023 US 202318314248
(71) Applicant: Avago Technologies International Sales Pte. Limited, Singapore 768923 (SG)
(72) Inventor: Tsang, Kwok Cheung, Irvine, 92620 (US); Wang, Hsi-Wei, 302 Zhubei City, Hsinchu County (TW); Huang, Wen-Hsien, 30072 East Dist., Hsinchu City (TW); Yu, Chia-Yuan, 302 Zhubei City, Hsinchu County (TW)
(74) Representative: Dilg, Haeusler, Schindelmann Patentanwaltsgesellschaft mbH

(57) **Abstract**

The present invention is directed to semiconductor devices and manufacturing methods. According to an embodiment, the present invention provides a semiconductor have includes a circuit that is coupled to a substrate. The substrate comprises a plurality of layers, some of which comprise organic material. In some implementations, the substrate may be a coreless substrate that is free from a core material. There are other embodiments as well.

## Description

### FIELD OF INVENTION

The present invention is directed to semiconductor devices and manufacturing methods.

### BACKGROUND OF THE INVENTION

Over the past few decades, semiconductor packaging material and processes have evolved. Various approaches involve using core material-which provides high thermal conductivity and structure support-as the "core" of a semiconductor substrate. For example, a substrate may be made by bonding copper foil to a core material such as alumina or aluminum nitride. Lately, "coreless" substrates have become more and more popular. Coreless substrate is a type of organic substrate that does not have a core layer, and it allows for a high level of wireability at lower cost and better electrical performance, as compared to multi-layer substrates with cores.

Various approaches for coreless substrates have been explored, but they have proven to be insufficient. It is important to recognize the need for new and improved coreless substrates and their manufacturing processes.

### BRIEF DESCRIPTION OF THE DRAWINGS

Figure 1A and 1B are a simplified diagram illustrating carrier layers used for manufacturing semiconductor substrates according to embodiments of the present invention.
Figure 2A and 2B are a simplified diagram illustrating substrate layers formed on carrier layers according to embodiments of the present invention.
Figure 3A and 3B are a simplified diagram illustrating solder masks formed on substrate layers according to embodiments of the present invention.
Figure 4A and 4B are a simplified diagram illustrating a process of separating two carrier layers according to embodiments of the present invention.
Figure 5 is a simplified diagram illustrating electrical contacts formed on a top surface of a semiconductor substrate that is mounted on a carrier layer according to embodiments of the present invention.
Figure 6 is a simplified diagram illustrating a circuit mounted on a semiconductor substrate that is mounted on a carrier layer according to embodiments of the present invention.
Figure 7 is a simplified diagram illustrating a filling material formed between a circuit and a semiconductor substrate that is mounted on a carrier layer according to embodiments of the present invention.
Figure 8 is a simplified diagram illustrating a head spreader overlaying a circuit and semiconductor substrate that is mounted on a carrier layer according to embodiments of the present invention.
Figure 9 is a simplified diagram illustrating a semiconductor device where a carrier layer has been removed according to embodiments of the present invention.
Figure 10 is a simplified diagram illustrating electrical contacts formed on a bottom surface of a semiconductor substrate according to embodiments of the present invention.

### DETAILED DESCRIPTION OF THE INVENTION

The present invention is directed to semiconductor devices and manufacturing methods. According to an embodiment, the present invention provides a semiconductor have includes a circuit that is coupled to a substrate. The substrate comprises a plurality of layers, some of which comprises organic material. In some implementations, the substrate may be a coreless substrate that is free from a core material. There are other embodiments as well.

As previously noted, existing methods for creating coreless substrates have proven to be insufficient, with one major limitation being their lack of mechanical rigidity. Organic coreless components bear technical similarities to structures with cores; however, when their dimensions exceed 50mm, they become too fragile for substrate and assembly suppliers to manage. This vulnerability arises from their increased size and absence of a core, making them more susceptible to damage during handling and assembly.

In various embodiments, the present invention introduces methods for producing coreless substrates. For instance, a coreless substrate manufacturing process consists of multiple stages, ranging from the initial phase to the final phase, in which a carrier supports the manufacturing procedure. The incorporation of a carrier resolves the production issue, guaranteeing a seamless process. Once the coreless substrate is fabricated with the assistance of a carrier, it is transported to assembly suppliers for die flip, reflow, underfill, and heat sink (HS) attachment. It should be noted that this approach addresses the assembly challenge, as large and delicate coreless substrates are difficult to manipulate without a carrier. For example, after the underfill and HS attachment, assembly suppliers can remove the carrier and proceed with subsequent steps, such as solder ball attachment. This ensures a streamlined assembly process, enhancing the overall quality of the final product.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the present invention is not intended to be limited to the embodiments presented, but is to be accorded the widest scope consistent with the principles and novel features disclosed herein.

In the following detailed description, numerous specific details are set forth in order to provide a more thorough understanding of the present invention. However, it will be apparent to one skilled in the art that the present invention may be practiced without necessarily being limited to these specific details. In other instances, well-known structures and devices are shown in block diagram form, rather than in detail, in order to avoid obscuring the present invention.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes a semiconductor device that includes a circuit that includes a first plurality of electrical contacts. The device also includes a substrate coupled to the circuit. The substrate may be characterized by a width of at least 50mm. The substrate may include a top layer that may include a second plurality of electrical contacts and a first organic material. The second plurality of electrical contacts may be coupled to the first plurality of electrical contacts. The substrate may further include a bottom layer that may include a third plurality of electrical contacts and a second organic material. The substrate may also include a plurality of substrate layers positioned between the top layer and the bottom layer. The plurality of substrate layers may include a fourth plurality of electrical contacts providing electrical connections between the first plurality of electrical contacts and the third plurality of electrical contacts.

Implementations may include one or more of the following features. The bottom layer may include a ball grid array (BGA) layer. The bottom layer may include a land grid array

(LGA) layer. The substrate may be free from core material. The substrate may include a coreless substrate. The top layer may include a solder mask material. The plurality of substrate layers may include a glass fiber material. The plurality of substrate layers may include a hybrid material. The plurality of substrate layers may include a pre-preg composite material. The substrate may include fewer than 20 layers.

According to another embodiment, the present invention provides a semiconductor package that includes a first carrier layer. The semiconductor package also includes a substrate coupled to the first carrier layer. The substrate may be characterized by a width of at least 70mm. The substrate may include a top layer that may include a first plurality of electrical contacts and a first organic material. A second plurality of electrical contacts may be coupled to the first plurality of electrical contacts. The substrate may also include a bottom layer that may include a second plurality of electrical contacts and a second organic material. The substrate may further include a plurality of substrate layers positioned between the top layer and the bottom layer. The plurality of substrate layers may include a third plurality of electrical contacts providing electrical connections between the first plurality of electrical contacts and the second plurality of electrical contacts.

Implementations may include one or more of the following features. The substrate may be free from core material. The top layer may include a solder mask material. The bottom layer may include a ball grid array (BGA) layer. The first carrier layer may include a core material, a glass material, or an organic material. The first carrier layer may include a first surface and a second surface. The first surface may be coupled to the bottom layer. The second surface may be detached from a second carrier layer.

According to yet another embodiment, the present invention provides a method for manufacturing a semiconductor substrate. The method may include providing a first carrier layer. The method also includes providing a second carrier layer, the second carrier layer being coupled to the first carrier layer. The method also includes depositing a first base layer on the first carrier layer. The first base layer may include a first plurality of electrical contacts. The method also includes depositing a second base layer on the second carrier layer, the second base layer may include a second plurality of electrical contacts. The method also includes forming a first plurality of substrate layers overlaying the first base layer. The first plurality of substrate layers may include a third plurality of electrical contacts coupled to the first plurality of electrical contacts. The method also includes forming a second plurality of substrate layers overlaying the second base layer. The second plurality of substrate layers may include a fourth plurality of electrical contacts coupled to the second plurality of electrical contacts. The method also includes forming a first contact layer overlaying the first plurality of substrate layers. The first contact layer may include a fifth plurality of electrical contacts coupled to the third plurality of electrical contacts. The method also includes forming a second contact layer overlaying the second plurality of substrate layers. The second contact layer may include a sixth plurality of electrical contacts coupled to the fourth plurality of electrical contacts. The method also includes detaching the first carrier layer from the second carrier layer. The method also includes detaching the first carrier layer from the first base layer. The method also includes processing the first base layer. The method also includes coupling the first carrier layer to the first base layer.

Implementations may include one or more of the following features. The method may include etching the first base layer, the first carrier layer being detached. The method may include coupling a circuit to the first contact layer. The method may include coupling a ball grid array to the first base layer and coupling a heat spreader to the circuit.

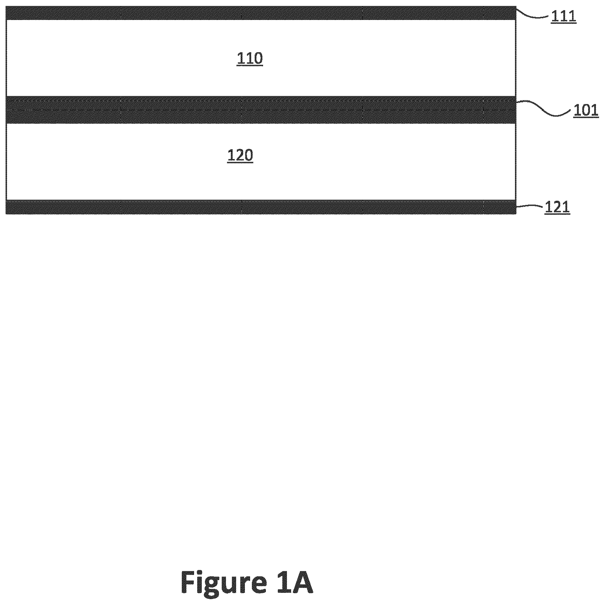

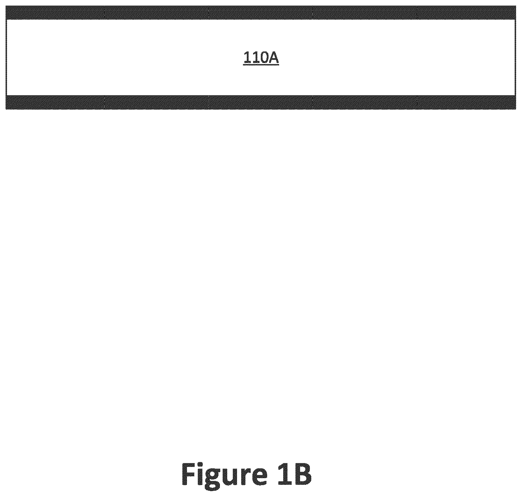

Figure 1A and 1B are a simplified diagram illustrating carrier layers used for manufacturing semiconductor substrates according to embodiments of the present invention. This diagram is merely an example, which should not unduly limit the scope of the claims. One of ordinary skill in the art would recognize many variations, alternatives, and modifications. Carrier layers 110 and 120, as shown in Figure 1, are coupled to each other. In some embodiments, carrier layer 110 and carrier layer 120 are coupled to each other by adhesive and/or other mechanisms. In certain embodiments, carrier layer 110 and carrier layer 120 are parts of the same piece of carrier block, and carrier layer 110 and carrier layer 120 are later separated from each by cutting, dicing, and/or or other processes. As an example, carrier layer 110 may include top layer 111, and carrier layer 120 may include bottom layer 121.

As an example, the term "carrier" refers to a material or device that holds and protects the semiconductor die during processing, storage, or transport. There are different types of carriers depending on the packaging technology and application. For example, a carrier according to embodiments of the present invention may include one or more materials such as organic material, core material, glass material, and/or others. Depending on the particular application, carriers may possess attributes such as heat dissipation capabilities, identification codes, alignment marks, or other features. For example, carrier layers 110 and 120 are engineered to provide structural rigidity and support for the formation and processing of semiconductor substrates.

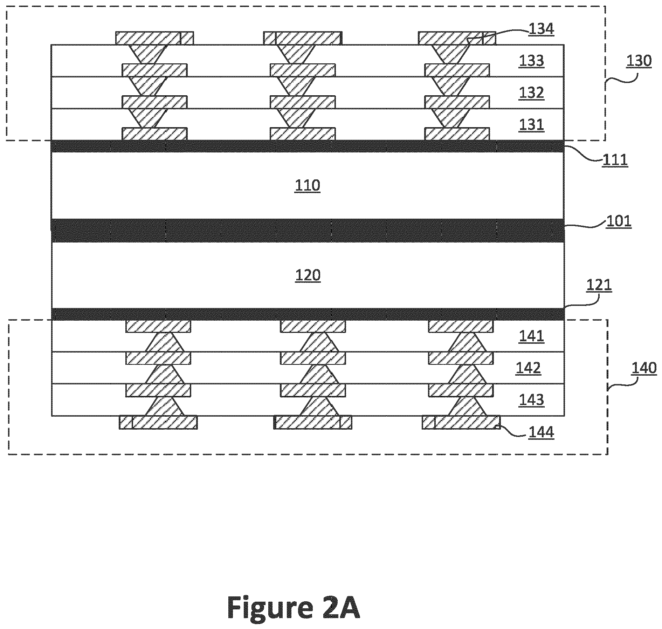

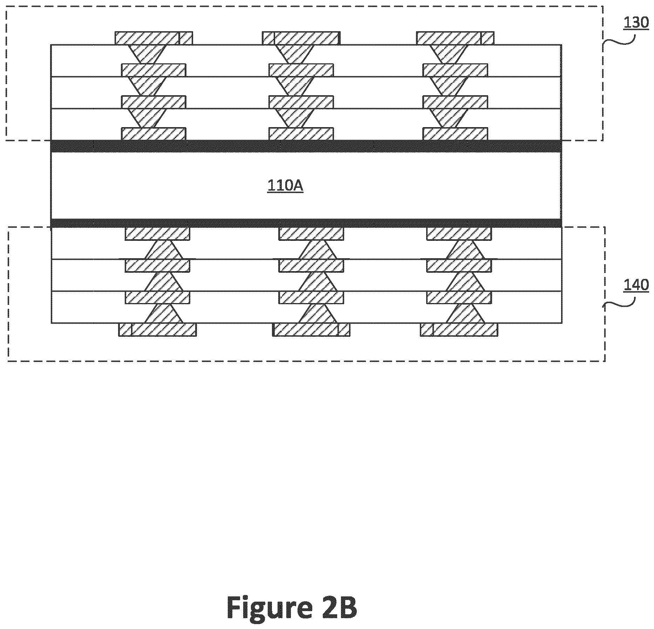

Figure 2A and 2B are a simplified diagram illustrating substrate layers formed on carrier layers according to embodiments of the present invention. This diagram is merely an example, which should not unduly limit the scope of the claims. One of ordinary skill in the art would recognize many variations, alternatives, and modifications. Substrate 130 is coupled to top surface 111 of carrier layer 110; substrate 140 is coupled to bottom surface 121 of carrier layer 120. For instance, substrates 130 and 140 can be formed layer by layer on carrier layers 110 and 120, respectively, through deposition or other buildup processes. For instance, carrier layers 110 and 120 can be subsequently separated (e.g., at region 101) from each other, facilitating the creation of two distinct substrates, 130 and 140. Substrate 130, as an example, is a coreless substrate consisting of multiple layers of semiconductor material, and may be free of organic core material. The term "coreless" indicates that the substrate lacks a core layer, which typically contains an organic core material, which may comprise organic small molecules or polymers. For example, substrates 130 and 140 are characterized by a width of at least 50mm and a composition of fewer than 20 layers. For instance, substrates 130 and 140 may have a width of at least 50mm and consist of fewer than 20 layers. It is important to note that mechanical rigidity becomes a crucial factor for coreless substrates with a width of 50mm or greater, especially during processing and transportation. For example, when attached to a carrier, substrates with width greater than 70mm or 100mm may be supported as well.

As illustrated, substrate 130 comprises layers 131, 132, and 133. These layers, for instance, may contain organic material and support high-density interconnects (HDI), thereby enabling substrate designs with fewer layers compared to some conventional approaches, as more connections can be established on a single layer. Electrical contact 134, for instance, is coupled to the electrical interconnects of layers 131 and 132. Each of layers 131, 132, and 133 may contain electrical connections and/or contacts formed during substrate buildup processes. For instance, electrical contact 134 may be electrically connected to electrical contacts of layers 131 and 132, while various electrical contacts of layers 131 and 132 may be electrically interconnected according to the specific substrate design.

Depending on the application, various passive components-such as resistors, capacitors, and inductors-may be embedded within substrate 130. This may conserve space on the outer layers, allowing for more efficient routing and reducing the necessity for additional layers.

Substrate 130 may comprise various types of materials. For instance, coreless buildup material, such as GL102 material, can be utilized. GL102 material refers to a buildup film material that consists of, among other components, a 100-µm-thick glass core, with 15-µm ABF GL102 laminated on both sides. Other buildup materials, such as GL107, NQ07XP, QX02, or others, may also be employed. Furthermore, materials like glass fiber material, pre-preg material, or hybrid material (e.g., a combination of different materials) can be used to form substrate 130 as well.

In certain embodiments, layer 131 may serve as the bottom layer of substrate 130, featuring electrical contacts designed for executing a ball grid array (BGA) configuration. Depending on the specific implementation, layer 131 could also function as an intermediate layer, with the possibility of forming one or more additional layers after separating carrier 110 from layer 131. In some embodiment, layer 131 may include electrical contacts for land grid array (LGA) configuration. For example, layer 131 may be referred to as a base layer of substrate 130.

As depicted, substrate 140 is connected to carrier 120. Depending on the application, substrate 140 may be formed on carrier 120 (e.g., as described earlier for substrate 130). Substrate 140 comprises layers 141, 142, and 143. The bottom surface of layer 143, as shown, remains exposed, allowing electrical contact 144 to be subsequently connected to other components, such as a circuit or a BGA.

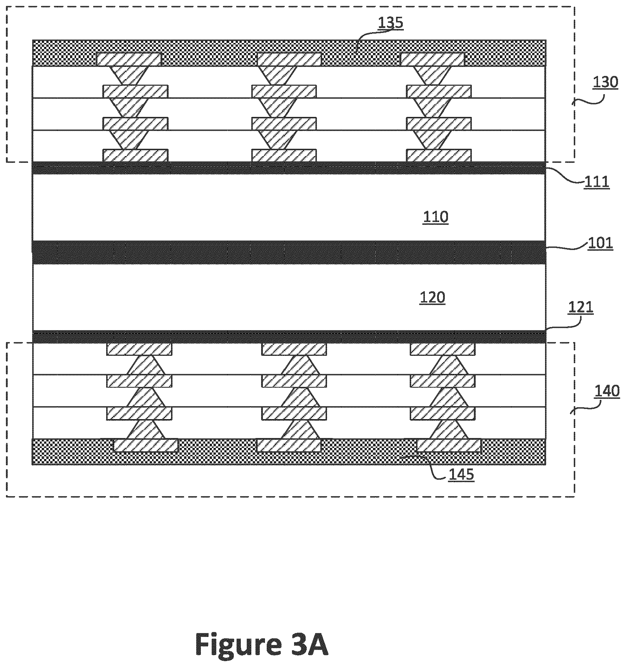

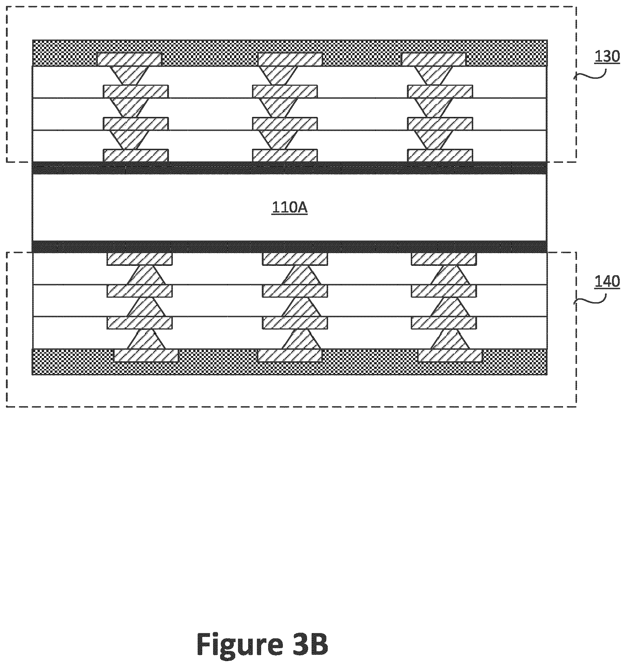

Figure 3A and 3B are a simplified diagram illustrating solder masks formed on substrate layers according to embodiments of the present invention. This diagram is merely an example, which should not unduly limit the scope of the claims. One of ordinary skill in the art would recognize many variations, alternatives, and modifications. Solder mask 135 is applied to the exposed surface of substrate 130, which is connected to carrier 110 at region 111, while solder mask 145 is applied to the exposed surface of substrate 140, connected to carrier 120 at region 121. Depending on the implementation, solder mask materials may consist of wet film, dry film, or other types. For instance, solder masks 135 and 145 may be designed for flip-chip packaging. For example, flip-chip refers to a technique for connecting circuits to external circuitry using solder bumps deposited onto the chip pads.

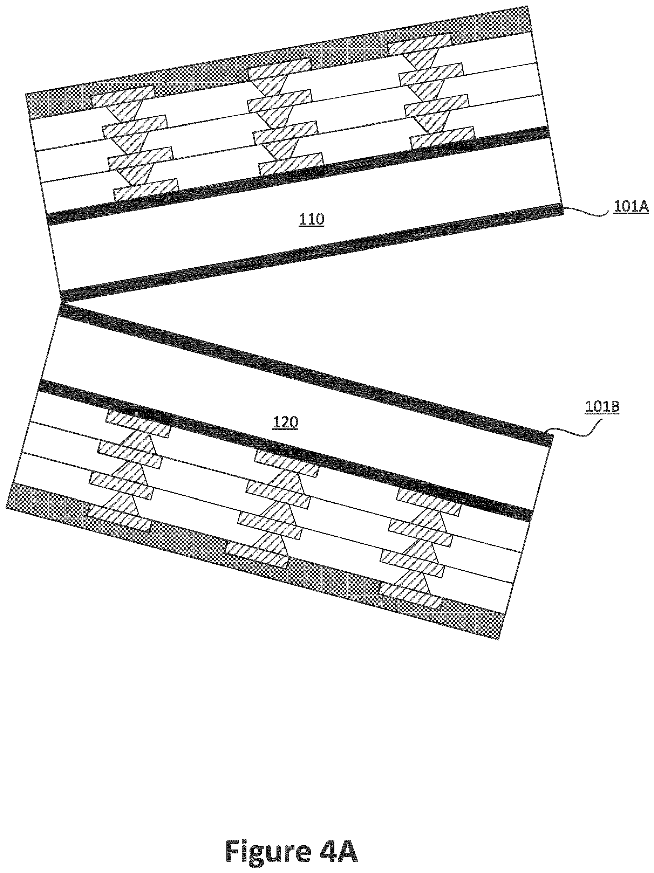

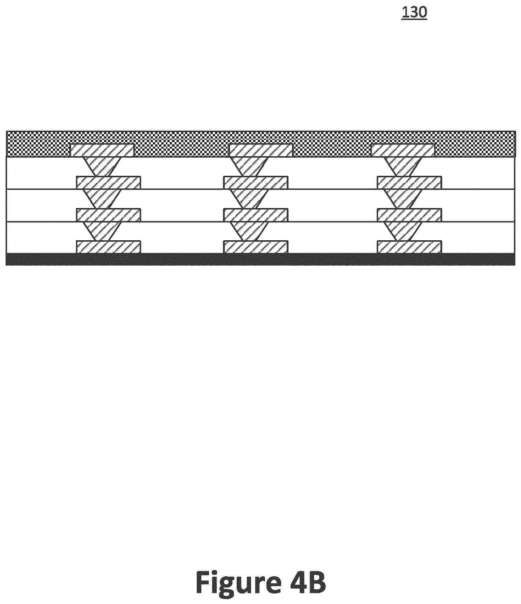

Figure 4A and 4B are a simplified diagram illustrating a process of separating two carrier layers according to embodiments of the present invention. This diagram is merely an example, which should not unduly limit the scope of the claims. One of ordinary skill in the art would recognize many variations, alternatives, and modifications. As illustrated, carriers 110 and 120 are separated from each other, with regions 101A of carrier 110 and 101B of carrier 120 now exposed. Meanwhile, substrates mounted on carriers 110 and 120 remain attached to their respective carriers. Carriers 110 and 120 can be detached from one another through various methods, depending on the process. As previously mentioned, carriers 110 and 120 may have been connected using adhesives and can be separated through mechanical and/or chemical processes. In some embodiments, carriers 110 and 120 were from a larger carrier block, from which they are separated by a cutting procedure.

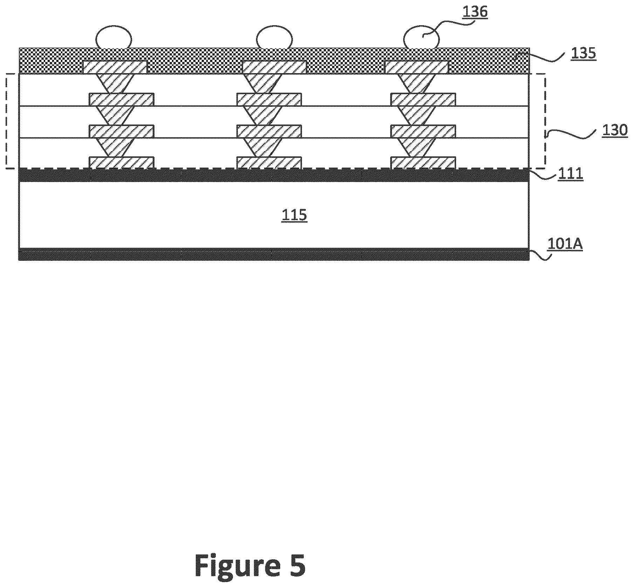

Figure 5 is a simplified diagram illustrating electrical contacts formed on a top surface of a semiconductor substrate that is mounted on a carrier layer according to embodiments of the present invention. This diagram is merely an example, which should not unduly limit the scope of the claims. One of ordinary skill in the art would recognize many variations, alternatives, and modifications. It should be noted that several backend processes can be conducted while the substrate is connected to carrier 110 at region 111. The term "backend processes" refers to operations executed after a substrate has been formed. These processes may include surface finishing, solder on pad (SOP) processes, testing, inspection, and more. For example, in an SOP process, solder may be applied by screening printing or by solder ball dropping. Metal bump 136, as illustrated, is located on solder mask layer 135, which overlays substrate 130. For example, the term "metal bump" refers to a coating on the substrate that is used to connect the substrate to a circuit in a flip-chip bonding process. In various implementations, a partially processed coreless substrate (for instance, before circuit and heat sink attachment) with the carrier attached, as depicted in Figure 5, can be transferred between different manufacturing entities. Coreless substrates typically have lower mechanical strength and rigidity compared to other approaches. Carrier 110 offers mechanical support for substrate 130, thus simplifying shipping and processing.

After completing various processes (such as backend processes, shipping, etc.), carrier 110 is detached from substrate 130, separating at region 111. Detaching carrier 110 from substrate 130 allows for various processes to be executed since the bottom surface of substrate 130 is now accessible (previously coupled to substrate 130 at region 111). For example, processes such as open short test and visual inspection may be performed with exposed bottom surface of substrate 130. Carrier 110 may be detached from substrate 130 in various ways. For example, a buffer layer may be positioned at region 111 to allow for easy detachment. For example, mechanical and/or chemical processes may be used to separate carrier 110 from substrate 130. Depending on the implementation, a flashing etching process might be performed to eliminate unnecessary metal seed layers without damaging the metal circuit layer, which requires the exposure of the bottom surface of substrate 130. Other processes, like solder masking, surface polishing, and more, can also be carried out.

After various processes have been performed, a carrier 115 is attached to substrate 130. For example, carrier 115 is a "fresh" carrier, not the carrier 110 that had been used. For example, adhesives or other mechanisms may be used to attach carrier 115 to substrate 130.

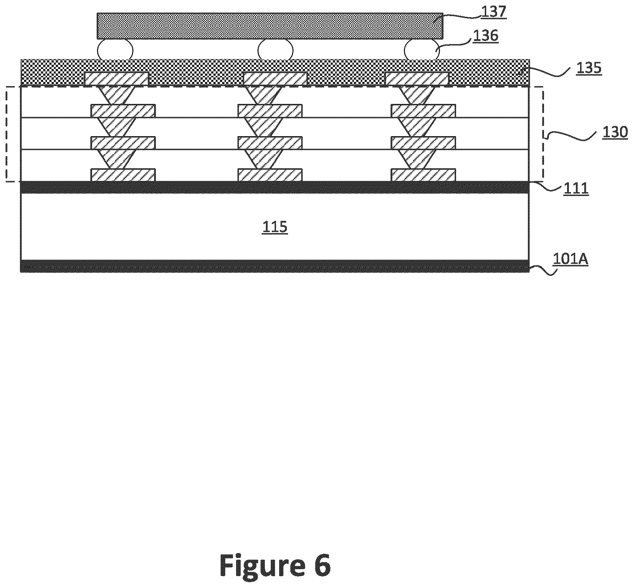

Figure 6 is a simplified diagram illustrating a circuit mounted on a semiconductor substrate that is mounted on a carrier layer according to embodiments of the present invention. This diagram is merely an example, which should not unduly limit the scope of the claims. One of ordinary skill in the art would recognize many variations, alternatives, and modifications. As depicted in Figure 6, circuit 137 is coupled to substrate 130 through metal bumps, including metal bump 136, using a flip-chip bonding technique. In various implementations, circuit 137 is coupled to substrate 130 while substrate 130 remains coupled to carrier 115 at region 111. In certain embodiments, circuit 137 is coupled to substrate 130 in a single-die configuration. In other cases, multiple circuits or dies can be stacked on the substrate using a 2.5D arrangement, where silicon or organic interposers may be employed.

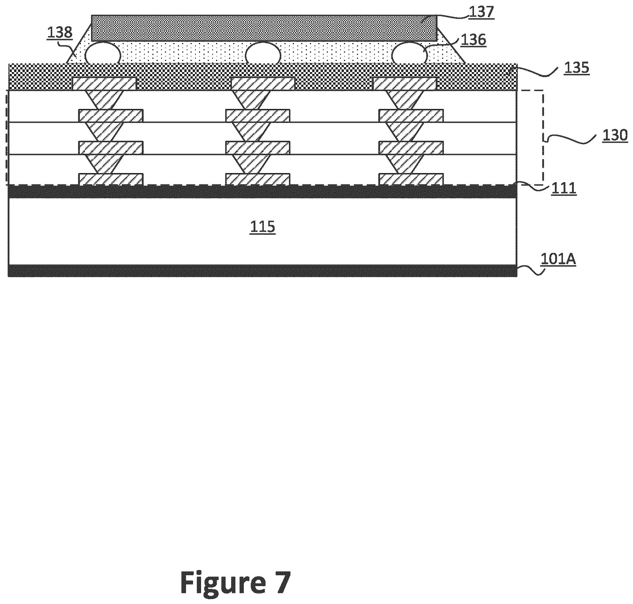

Figure 7 is a simplified diagram illustrating a filling material formed between a circuit and a semiconductor substrate that is mounted on a carrier layer according to embodiments of the present invention. This diagram is merely an example, which should not unduly limit the scope of the claims. One of ordinary skill in the art would recognize many variations, alternatives, and modifications. When carrier 115 is attached to substrate 130, filling material (also known as underfill) is added. The type of filling material used may vary depending on the implementation, such as an epoxy material applied around metal bumps (for instance, surrounding metal bump 136) and partially around circuit 137. An example of this process is the liquid capillary underfill method, which involves dispensing a void-free fluid to encapsulate the space between circuit 137 and layer 135, as illustrated in Figure 7. Other techniques, such as the mold underfill process using mold materials, can also be employed. Depending on the implementations, one or more passive components may be attached after the underfill processes.

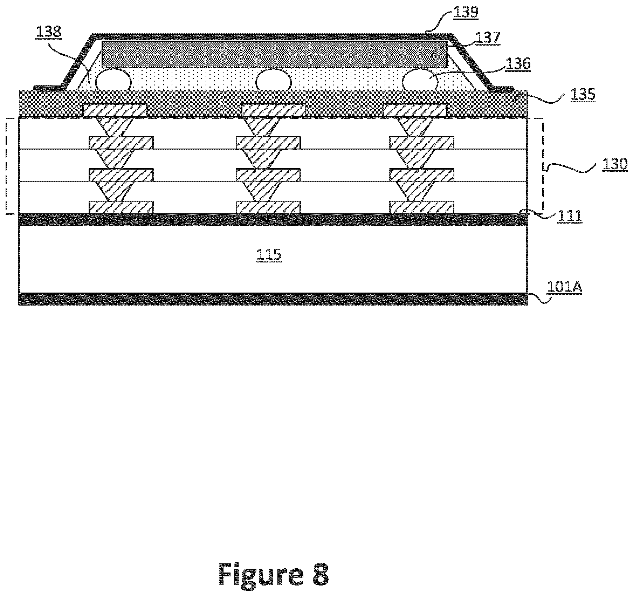

Figure 8 is a simplified diagram illustrating a head spreader overlaying a circuit and semiconductor substrate that is mounted on a carrier layer according to embodiments of the present invention. This diagram is merely an example, which should not unduly limit the scope of the claims. One of ordinary skill in the art would recognize many variations, alternatives, and modifications. As depicted in Figure 8, heat spreader 139 is thermally and/or physically connected to circuit 137. In various embodiments, a thermal interface material (TIM) may be placed between heat spreader 139 and circuit 137. Additional structures, such as a stiffener ring, can also be added to the substrate. In several implementations, elements like heat spreader 139 and the stiffener ring are attached while substrate 130 is connected to carrier 115 at region 111. For instance, when applying pressure to couple heat spreader 139 to substrate 130-which is coreless and lacks mechanical rigidity-carrier 115 provides mechanical support.

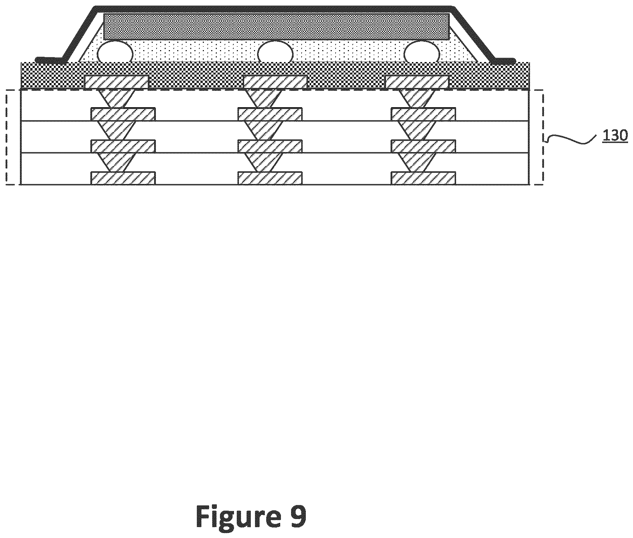

Figure 9 is a simplified diagram illustrating a semiconductor device where a carrier layer has been removed according to embodiments of the present invention. This diagram is merely an example, which should not unduly limit the scope of the claims. One of ordinary skill in the art would recognize many variations, alternatives, and modifications. As illustrated in Figure 9, the carrier (for instance, carrier 115 in Figure 8) is detached from substrate 130. The carrier can be detached from substrate 130 using various methods, such as a mechanical detachment process (including cutting, dicing, pulling, etc.), a chemical detachment process (such as the removal of the adhesive between substrate 130 and the carrier using chemicals), a laser detachment process, or other techniques.

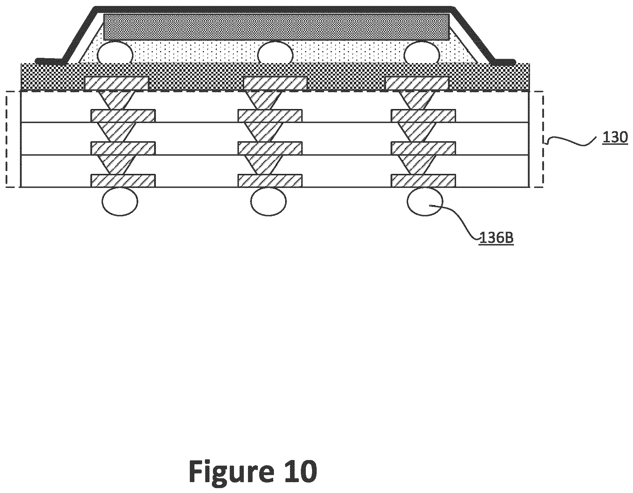

Figure 10 is a simplified diagram illustrating electrical contacts formed on a bottom surface of a semiconductor substrate according to embodiments of the present invention. This diagram is merely an example, which should not unduly limit the scope of the claims. One of ordinary skill in the art would recognize many variations, alternatives, and modifications. Electrical contacts, such as metal ball 136B in a BGA configuration, are placed on the bottom surface of substrate 130, which is exposed after the carrier's removal. Other structures or elements may also be formed on the bottom surface or other parts of substrate 130. Additional processes, including the removal of excess electrical contact material, can be carried out as well. Depending on the implementation, LGA or other configurations may be used as well.

While the above is a full description of the specific embodiments, various modifications, alternative constructions and equivalents may be used. Therefore, the above description and illustrations should not be taken as limiting the scope of the present invention which is defined by the appended claims.

## Claims

1. A semiconductor device comprising:
a circuit comprising a first plurality of electrical contacts; and
a substrate coupled to the circuit, the substrate being **characterized by** a width of at least 50mm, wherein the substrate comprises:
a top layer comprising a second plurality of electrical contacts and a first organic material, the second plurality of electrical contacts being coupled to the first plurality of electrical contacts;
a bottom layer comprising a third plurality of electrical contacts and a second organic material; and
a plurality of substrate layers positioned between the top layer and the bottom layer, the plurality of substrate layers comprising a fourth plurality of electrical contacts configured to provide electrical connections between the first plurality of electrical contacts and the third plurality of electrical contacts.

2. The semiconductor device of claim 1, wherein
the bottom layer comprises a ball grid array (BGA) layer.

3. The semiconductor device of claim 1 or 2, wherein
the bottom layer comprises a land grid array (LGA) layer.

4. The semiconductor device of any one of the claims 1 to 3, wherein
the substrate is free from an organic core material.

5. The semiconductor device of any one of the claims 1 to 4, wherein
the substrate comprises a coreless substrate.

6. The semiconductor device of any one of the claims 1 to 5, wherein
the top layer comprises a solder mask material.

7. The semiconductor device of any one of the claims 1 to 6, wherein the semiconductor device comprises at least one of the following features:
the plurality of substrate layers comprises a glass fiber material;
the plurality of substrate layers comprises a hybrid material;
the plurality of substrate layers comprises a pre-preg composite material;
the substrate consists of fewer than 20 layers.

8. A semiconductor package comprising:
a first carrier layer; and
a substrate coupled to the first carrier layer, the substrate being **characterized by** a width of at least 70mm, wherein the substrate comprises:
a top layer comprising a first plurality of electrical contacts and a first organic material, a second plurality of electrical contacts being coupled to the first plurality of electrical contacts;
a bottom layer comprising a second plurality of electrical contacts and a second organic material; and
a plurality of substrate layers positioned between the top layer and the bottom layer, the plurality of substrate layers comprising a third plurality of electrical contacts providing electrical connections between the first plurality of electrical contacts and the second plurality of electrical contacts.

9. The semiconductor package of claim 8, wherein
the substrate is free from an organic core material.

10. The semiconductor package of claim 8 or 9, wherein
the top layer comprises a solder mask material;
and/or
the bottom layer comprises a ball grid array (BGA) layer.

11. The semiconductor package of any one of the claims 8 to 10, wherein
the first carrier layer comprises a ceramic material, a glass material, or an organic material.

12. The semiconductor package of any one of the claims 8 to 11, wherein
the first carrier layer comprises a first surface and a second surface, the first surface being coupled to the bottom layer, the second surface being detached from a second carrier layer.

13. A method for manufacturing a semiconductor substrate, the method comprising:
providing a first carrier layer;
providing a second carrier layer, the second carrier layer being coupled to the first carrier layer;
depositing a first base layer on the first carrier layer, the first base layer comprising a first plurality of electrical contacts;
depositing a second base layer on the second carrier layer, the second base layer comprising a second plurality of electrical contacts;
forming a first plurality of substrate layers overlaying the first base layer, the first plurality of substrate layers comprising a third plurality of electrical contacts coupled to the first plurality of electrical contacts;
forming a second plurality of substrate layers overlaying the second base layer, the second plurality of substrate layers comprising a fourth plurality of electrical contacts coupled to the second plurality of electrical contacts;
forming a first contact layer overlaying the first plurality of substrate layers, the first contact layer comprising a fifth plurality of electrical contacts coupled to the third plurality of electrical contacts;
forming a second contact layer overlaying the second plurality of substrate layers, the second contact layer comprising a sixth plurality of electrical contacts coupled to the fourth plurality of electrical contacts;
detaching the first carrier layer from the second carrier layer;
detaching the first carrier layer from the first base layer;
processing the first base layer; and
coupling the first carrier layer to the first base layer.

14. The method of claim 13, further comprising
etching the first base layer, the first carrier layer being detached.

15. The method of claim 13 or 14, further comprising
coupling a circuit to the first contact layer;
and/or
coupling a ball grid array to the first base layer; and
coupling a heat spreader to the circuit.
